# EUROPÄISCHE PATENTSCHRIFT

(11) **EP 1 310 782 B1**
(45) Veröffentlichungstag und Bekanntmachung des Hinweises auf die Patenterteilung: **16.08.2006**
(21) Anmeldenummer: 01126740.8
(22) Anmeldetag: 09.11.2001
(51) Int. Cl.: G01M 11/00, G01M 11/02, G01K 17/00

(54) **Verfahren und Vorrichtung zur Erfassung von Informationen für die Überwachung einer Laseranordnung**
Method and device for recording information for monitoring a laser device
Procédé et dispositif de saisie d'informations pour le contrôle d'un dispositif laser

(43) Veröffentlichungstag der Anmeldung: 14.05.2003
(73) Patentinhaber: TRUMPF Werkzeugmaschinen GmbH + Co. KG, 71254 Ditzingen (DE)
(72) Erfinder: Kircher, Steffen, 70178 Stuttgart (DE)
(74) Vertreter: Maser, Jochen

(56) Entgegenhaltungen:
- CH-A- 690 796
- DE-A- 4 431 966
- DE-C- 10 007 976
- DE-U- 1 918 760
- FR-A- 2 698 495
- US-A- 4 283 378
- US-A- 4 692 623
- PROMETEC GMBH: "In-Process-Messung und Überwachung von unfokussierter Laserstrahlung - Laserscope UFC 60" -, [Online] 11. Januar 2001 (2001-01-11), XP002197030 Gefunden im Internet: <URL:http://www.prometec.de/german/pages/f ramesets/laser_diagnostics.htm> [gefunden am 2002-04-16]
- PATENT ABSTRACTS OF JAPAN vol. 011, no. 367 (E-561), 28. November 1987 (1987-11-28) & JP 62 139374 A (MATSUSHITA ELECTRIC IND CO LTD), 23. Juni 1987 (1987-06-23)

## Beschreibung

Die Erfindung betrifft ein Verfahren und eine Vorrichtung zur Erfassung von Informationen an optischen Elementen, insbesondere für die Überwachung einer Laseranordnung, welche zumindest zur Bestimmung einer Leistung einer elektromagnetischen Strahlung entlang eines Strahlweges und zur Bestimmung eines Verschmutzungsgrades, einer Alterung oder einer beginnenden Zerstörung von optischen Elementen eingesetzt wird.

Aus der Offenlegungsschrift DE 196 36 249 A1 ist eine Vorrichtung zum Schutz von optischen Komponenten bekannt geworden, deren Ziel es ist, eine voranschreitende Zerstörung von optischen Elementen rechtzeitig zu erkennen und zu verhindern. Dadurch soll eine vollständige Zerstörung der optischen Elemente vermieden werden, so daß die teilweise zerstörte Oberfläche der Komponenten rechtzeitig poliert und neu entbeziehungsweise verspiegelt werden kann, wodurch gegenüber einem Austausch durch ein neues optisches Element eine erhebliche preisliche Einsparung erzielt wird.

Zur Erkennung einer voranschreitenden Zerstörung sind vor und hinter dem optischen Element durchbohrte Streuscheiben vorgesehen, welche bei der beginnenden Zerstörung des optischen Elementes den Laserstrahl streuen, wodurch das auftretende Streulicht aufgrund der Zerstörung durch die Streuscheiben in Richtung auf Detektoren umgelenkt wird. Beim Überschreiten eines bestimmten Streulichtkegels wird ein Signal ausgegeben, durch welches das Lasernetzteil eines Oszillators unmittelbar abgeschalten wird. Diese Anordnung weist den Nachteil auf, daß zusätzliche Komponenten erforderlich sind, die in dem Strahlengang angeordnet werden müssen, um eine mögliche beginnende Zerstörung der optischen Komponenten zu erfassen. Eine derartige Vorrichtung ist in einer Laseranordnung nur bedingt aufgrund des benötigten Einbauraumes der Komponenten einsetzbar. Darüber hinaus kann durch diese Vorrichtung die Laserleistung nicht überwacht werden.

Aus der FR 2 698 495 geht ein Verfahren zur Messung einer Temperatur von einer Linse hervor, die in einer Laseranordnung vorgesehen ist. Zur Erfassung der Temperatur der Linse ist ein erstes Thermoelement vorgesehen, das am Rand der Linse angebracht ist. Ein weiteres Temperaturelement ist auf einer Vorderseite eines Ausgangs der Linse außerhalb des Strahlenganges angeordnet. Ein drittes Thermoelement ist an einer Schulter für eine Aufnahme der Linse angebracht. Diese drei Thermoelemente sind jeweils um 120° zueinander versetzt angeordnet und leiten die erfasste Temperatur an eine Auswerteeinheit weiter. Sobald die Temperatur einen Schwellwert überschritten hat, wird ein Alarmsignal ausgegeben.

Durch die Anordnung der Thermoelemente auf der Linse und Linsenaufnahme werden Einzelmessungen an den jeweiligen Kontaktstellen der Thermoelemente zur Linse durch die Thermoelemente durchgeführt.

Aus der JP 62 139374 A ist eine Vorrichtung bekannt, bei welcher mit einem Laserstrahl eine Bearbeitung erfolgt. Der Laserstrahl wird über Spiegel und Linsen abgelenkt. Zur Erkennung von Alterung oder Verschmutzung weisen die Spiegel und Linsen einen Temperaturdetektor auf.

Aus einem Prospekt der Firma Prometec mit dem Titel "Laserscope UFC 60" ist eine Vorrichtung bekannt, durch welche eine kontinuierliche Vermessung und Überwachung unfokussierter Laserstrahlung von Lasern mit hoher Leistung, welche vornehmlich in der Laserbearbeitung elngesetzt wird, ermöglicht ist. Die Vorrichtung arbeitet nach dem Meßprinzip, wonach ein Draht seinen elektrischen Widerstand erhöht, wenn sich seine Temperatur aufgrund absorbierter Strahlung erhöht. Zur Ermittlung von Meßdaten sind mehrere übereinander angeordnete Gitter mit extrem dünnen, nebeneinander angeordneten Drähten vorgesehen. Zur Strahlüberwachung wird ein Gerät mit zwei übereinandergelagerten Gittern vorgeschlagen, wobei diese die Gitter aufnehmende Vorrichtung derart in einem Strahlweg zu positionieren ist, daß der Laserstrahl diese Gitter durchlaufen kann.

Diese Vorrichtung ist somit aufgrund einem die Gitter aufnehmenden Gehäuse in einer Laseranordnung nur bedingt einsetzbar. Des weiteren sind die zur Erfassung von Informationen vorgesehenen Drähte äußerst empfindlich, da diese einen Durchmesser im unteren Mikrometerbereich aufweisen und sehr leicht brechen können. Insbesondere ist eine Kühlung der Gitter für eine exakte Messung schwer möglich, da die Drähte bei einer starken Luftströmung noch leichter brechen. Ohne Kühlung der Gitter sind die erfaßten Werte jedoch durch kontinuierliches Aufheizen der Gitter mit Fehlern behaftet. Des weiteren können sich Schmutzpartikel an dem Gitter anlagern und die Meßergebnisse zusätzlich verfälschen. Darüber hinaus ist diese Vorrichtung nicht in einem Lasergerät einsetzbar. Auch kann die Verschmutzung, Alterung oder beginnende Zerstörung von optischen Elementen nicht erfaßt werden.

Aus der US-PS 4,692,623 ist eine Vorrichtung bekannt, die zur Erfassung einer Lage und einer Position eines Laserstrahles vorgesehen ist. Diese Vorrichtung weist auf einem Glassubstrat ein Gitter von Leiterbahnen auf, wobei die Leiterbahnen in den Kreuzungspunkten zueinander isoliert sind. Diese Leiterbahnen können mit einer reflektierenden Beschichtung abgedeckt sein. Ein Detektor und eine Anzeigevorrichtung sind mit den Leiterbahnen zur Erfassung der Änderung des elektrischen Widerstandes aufgrund der absorbierten Wärme in dem Glassubstrat und den Leiterbahnen verbunden.

Eine analoge Anordnung ist aus der CH 690 796 A5 bekannt. Der in dieser Druckschrift offenbarte Spiegel unterscheidet sich von der vorhergehenden Vorrichtung nur dadurch, dass das Gitter der Leiterbahnen in zwei Ebenen durch eine Isolierung getrennt ausgebildet ist. Auf einer Isolierung auf dem Trägermaterial des Spiegels ist eine erste Lage aus einer Vielzahl von parallel zueinander angeordneten Leiterbahnen vorgesehen. Diese ist mit einer Isolierung abgedeckt, weiche wiederum eine zweite Lage von parallel zueinander laufenden Leiterbahnen aufnimmt. Die zweite Lage der Leiterbahnen ist um 90° zur ersten Lage gedreht ausgerichtet. Auch die zweite Lage der Leiterbahn ist durch eine Isolierung abgedeckt. Jeweils an den äußeren Enden der Leiterbahn sind Kontaktflächen zum Anschließen an eine Auswerteeinheit vorgesehen.

Die beiden vorgenannten Vorrichtungen gemäß der US-PS 4,692,623 und CH 690 796 A5 haben gemeinsam, dass die Leiterbahnen auf dem Trägermaterial der Vorrichtung aufgebracht sind. Dadurch wird die in den Trägermaterialien aufgrund von absorbierter Strahlung eines Laserstrahls bewirkte Temperaturänderung auf die Leiterbahnen übertragen, um daraus resultierend eine Änderung des elektrischen Widerstandes in den jeweiligen Leiterbahnen zu erfassen.

Der Erfindung liegt deshalb die Aufgabe zugrunde, ein Verfahren und eine Vorrichtung zur Erfassung von Informationen an optischen Elementen, insbesondere für die Überwachung und Qualitätssicherung einer Laseranordnung, zu schaffen, durch welche eine einfache und kostengünstige Erfassung der Leistung elektromagnetischer Strahlung entlang eines Strahlweges und die Erkennung eines Verschmutzungsgrades, einer beginnenden Alterung oder Zerstörung von optischen Elementen ermöglicht ist.

Diese Aufgabe wird erfindungsgemäß durch ein Verfahren gemäß dem Anspruch 1 und eine Vorrichtung gemäß dem Anspruch 9 gelöst.

Das erfindungsgemäße Verfahren weist den Vorteil auf, daß die in einem optischen Element absorbierte elektromagnetische Strahlung eine Änderung zumindest einer physikalischen Größe bewirkt und für die Prozeßüberwachung und Qualitätssicherung, insbesondere für eine Laseranordnung erfaßt und verwendet wird. Durch die in einem optischen Element absorbierte elektromagnetische Strahlung wird Wärme erzeugt. Dadurch wird die Änderung der elektrischen Leitfähigkeit an oder in dem optischen Element durch Messung des elektrischen Widerstands mit der Meßeinrichtung erfaßt. Somit erfolgt eine einfache Erfassung des Sekundärvorganges aufgrund der thermischen Änderung durch die Absorption. Die Änderung der physikalischen Größe dient als Infomationsquelle beispielsweise für die Überwachung der Leistung der elektromagnetischen Strahlung als auch für die Bestimmung des Verschmutzungsgrades oder einer beginnenden Zerstörung oder Alterung des optischen Elementes. Durch dieses Verfahren können einzelne oder alle optischen Elemente in einer Laseranordnung auf einfache Weise auf eine erhöhte Verschmutzung, Alterung oder eine beginnende Zerstörung hin überwacht werden, ohne daß zusätzliche Bauteile oder Gehäuse oder sonstige Komponenten in den Strahlengang eines elektromagnetischen Strahles einzubringen sind. Ebenso kann beispielsweise während des Betriebes einer Laseranordnung eine Überwachung der Leistung der elektromagnetischen Strahlung entlang des Strahlweges von dem Erzeugungsort bis zum Einsatzort erfolgen und eine mögliche Abweichung der Sollleisturig erfaßt und eine Fehlererkennung durchgeführt werden.

Dabei werden die erfassten Ist-Werte mit einem in der Auswerteeinheit hinterlegten Referenzwert verglichen werden. Bei einer solchen Auswertung wird berücksichtigt, daß sich der spezifische Widerstand eines Materials in Abhängigkeit der Temperatur ändert, welcher reziprok im Verhältnis zur elektrischen Leitfähigkeit steht. Der gemessene Widerstand ist abhängig vom spezifischen Widerstand, so daß durch einen Vergleich des Ist-Wertes mit dem Referenzwert eine Aussage über eine mögliche Abweichung der Leistung der elektromagnetischen Strahlung sowie auch der Leistung oder Veränderung des optischen Elements getroffen werden kann. Ebenso können weitere die durch die Relaxation und/oder Deaktivierungsprozesse bewirkte Vorgänge erfaßt werden.

Des weiteren weist das erfindungsgemäße Verfahren beim Einsatz in einer Laseranordnung den Vorteil auf, daß die Informationen sowohl an internen als auch externen optischen Elementen einer Laseranordnung erfaßt werden können. Als interne optische Elemente sind beispielsweise Umlenk-, Rück-, Auskoppel-, teiltransmittierende Spiegel und transmittierende Optiken, wie beispielsweise Linsen vorgesehen, die Im Lasergerät angeordnet sein können. Die externen optischen Elemente umfassen die strahlformenden und/oder strahlführenden Optiken, wie beispielsweise Umlenk-, Hohlspiegel und Fokussierlinsen. Darüber hinaus ist dieses Verfahren von der Leistung der Laser unabhängig und kann bei allen optischen Elementen durchgeführt werden.

Nach einer bevorzugten Ausgestaltung des Verfahrens ist vorgesehen, daß vor der Inbetriebnahme oder dem Einbau des oder der optischen Elemente in eine Laseranordnung ein Referenzwert des zumindest einen optischen Elements erfaßt wird. Somit kann jedem optischen Element ein spezifischer Referenzwert zugeordnet werden, um eine exakte Aussage über die Größe der Änderungen durch die Absorption zu erhalten und die Abweichungen des tatsächlich vorliegenden elektrischen Widerstandes der einzelnen optischen Elemente erfassen und berücksichtigen zu können.

Vorteilhafterweise ist vorgesehen, daß der Referenzwert und der beziehungsweise die Ist-Werte an dem Trägermaterial des optischen Elementes erfaßt werden. Als Trägermaterialien bei optischen Elementen in einer Laseranordnung werden sowohl metallische Materialien, wie beispielsweise Kupfer oder dergleichen, als auch Halbleitermaterialien, wie beispielsweise Silicium oder dergleichen, bevorzugt eingesetzt. Auch jegliche weitere Materialien oder Legierungen, welche ihren elektrischen Widerstand in Abhängigkeit der Temperatur ändern und die weiteren Anforderungen zum Einsatz für elektromagnetische Strahlungen erfüllen, sind geeignet.

Optische Elemente weisen zumeist metallische, aus Halbleltermaterial bestehende Beschichtungen oder dielektrische Schichten auf. Vorteilhafterweise sind mehrere Schichten aus leitfähigem, insbesondere elektrisch leitfähigem und nicht leitfähigem, insbesondere elektrisch nicht leitfähigem Material übereinanderliegend vorgesehen. Die Multilayerbeschichtung besteht beispielsweise aus Zinkselenid als Isolator und Germanium. Germanium hat beispielsweise die Eigenschaft, daß der elektrische Widerstand in Abhängigkeit der Temperatur sich ändert. Jegliche weitere Materialien, die diese oder ähnliche Eigenschaften aufweisen und sich als Beschichtung, insbesondere beim Einsatz eines Laserstrahls, eignen, sind ebenfalls einsetzbar. Alternativ zur elektrisch leitenden Beschichtung kann auch eine dielektrische Schicht, wie beispielsweise aus Thoriumtetrafluorid in Verbindung mit Zinkselenid, zur Bildung einer Multilayerbeschichtung vorgesehen sein. Der Aufbau der Multilayerbeschichtung kann auch davon abweichend ausgebildet sein. Beispielsweise können hochohmige und niederohmige Schichten direkt übereinander liegend oder auch mit einer oder mehreren Isolationsschichten kombiniert werden. Ebenso können mehr oder weniger dielektrische oder elektrisch leitende Schichten direkt übereinander liegend oder auch mit einer oder mehreren Isolationsschichten miteinander kombiniert werden. Dadurch lassen sich ebenfalls mehrere Meßebenen realisieren. Durch alle oben genannten Anordnungen kann die Ist-Werterfassung an mehreren Schichten durchgeführt werden, wodurch eine höhere Auflösung und bessere Bestimmung der Meßwerte ermöglicht ist. Dadurch kann auch die Strahllage der elektromagnetischen Strahlung zum optischen Element ermittelt werden.

Nach einer weiteren vorteilhaften Ausgestaltung der Erfindung ist vorgesehen, daß der Ist-Wert zeitverzögert nach einem erstmaligen Auftreffen von elektromagnetischer Strahlung auf das zumindest eine optische Element erfaßt wird. Dadurch kann sichergestellt werden, daß die Änderung der physikalischen Größe aufgrund der absorbierten Strahlung nahezu vollständig erfolgt ist, so daß ein quasi gleichbleibender Wert erfaßt wird. Somit kann eine weitere Änderung der physikalischen Größe während der Messung als Fehlerquelle ausgeschlossen werden.

Nach einer weiteren vorteilhaften Ausgestaltung der Erfindung ist vorgesehen, daß beim Überschreiten oder Unterschreiten eines zu dem Referenzwert wählbaren oberen und unteren Grenzwertes einer Leistung des elektromagnetischen Strahls ein Signal zur Warnung, Nachregelung oder Abschaltung der Laseranordnung von der Auswerteeinheit ausgegeben wird. Dadurch kann sichergestellt werden, daß Beschädigungen durch ansteigende Leistungen der Strahlung an Komponenten vermieden werden. Des weiteren kann bei der Laserbearbeitung eine gleichbleibende Qualität in der Bearbeitung erzielt werden. Beispielsweise beim Laserschweißen können somit Inhomogenitäten durch Schwankungen der Laserleistung beim Auftreffen auf das Werkstück dedektiert oder nachgeregelt werden.

Eine vorteilhafte Ausgestaltung sieht vor, daß zur Überwachung der Leistung des elektromagnetischen Strahles von zumindest zwei, vorzugsweise jedem optischen Element, Ist-Werte der Meßeinrichtung während des Betriebes der Anlage erfaßt werden, diese Ist-Werte mit einem gemeinsamen Referenzwert für alle optischen Elemente oder dem jeweiligen optischen Element zugeordneten Referenzwert in der Auswerteeinheit verglichen werden, eine betragsmäßige Abweichung ermittelt und einer entsprechenden Leistung der elektromagnetischen Strahlung, insbesondere der Laserleistung, gleichgesetzt wird. Vorzugsweise wird im Laserresonator durch einen thermischen Absorber die tatsächlich erzeugte Laserleistung erfaßt, welche mit dem oder den an den optischen Elementen erfaßten Laserleistungen verglichen werden. Dadurch kann der an jedem optischen Element erfaßte Ist-Wert mit der tatsächlich erzeugten Laserleistung verglichen und eine Abweichung in der abgebenden Laserleistung frühzeitig erkannt und erfaßt werden. Eine vollständige Überwachung der Laserleistung entlang des gesamten Strahlweges ist ermöglicht. Gleichzeitig kann ein erhöhter Verschmutzungsgrad an einem optischen Element oder eine beginnende Alterung oder Zerstörung erfaßt werden, da bei einer erhöhten Verschmutzung oder beginnenden Alterung oder Zerstörung eine erhöhte Absorption der Strahlung in dem optischen Element erfolgt und eine betragsmäßig größere Änderung, insbesondere des elektrischen Widerstandes, als die anderen optischen Elemente zur Folge hat. Somit kann das verschmutzte, gealterte oder teilweise zerstörte optische Element identifiziert werden. Sofern der erfaßte Ist-Wert einen in einer Auswerteeinheit vorgegebenen Grenzwert, der vorzugsweise frei wählbar ist, überschreitet, wird umgehend ein Signal ausgegeben und die Laseranordnung wird beispielsweise zur Sicherheit stillgesetzt, um Beschädigungen oder vollständige Zerstörungen zu vermeiden und das optische Element auszutauschen.

Die Überwachung der Laserleistung und des Grades der Verschmutzung beziehungsweise die Alterung oder teilweise Zerstörung können vorteilhafterweise in einen Onlineprozeß integriert werden. Dadurch können auch Protokolle über die Zeitdauer des Einsatzes der Laseranordnung erstellt werden, welche zur Auswertung von Daten, wie durchschnittliche Lebensdauer eines optischen Elementes, tatsächlich abgegebene Laserleistung für die Bearbeitung von Werkstücken und Materialien, Wartungsintervalle oder dergleichen, dienen und zur Erhöhung der Prozeßsicherheit und somit zur Qualitätssicherung beitragen.

Vorteilhafterweise können die Ist-Werte in frei wählbaren Zeitintervallen erfaßt werden. Dadurch kann die Erfassung der Informationen in Abhängigkeit der geforderten Qualitätssicherung und Überwachung durch die Meßeinheit ermittelt werden.

Nach einer vorteilhaften Ausgestaltung der Erfindung ist vorgesehen, daß eine Schar von Kennlinien für optische Elemente erfaßt und in der Auswerteeinheit gespeichert werden. Diese Kennlinien werden für jedes geeignete Trägermaterial und Beschichtungsmaterial und deren Kombination erfaßt. Durch einen Vergleich der Ist-Werte oder deren betragsmäßigen Änderungen mit den hinterlegten Kennlinien kann beim Einsatz der optischen Elemente in einer Laseranordnung eine spezifische Aussage über den aktuellen Zustand des optischen Elements und die Ursache der Zustandsänderung ermöglicht sein.

Die erfindungsgemäße Vorrichtung weist den Vorteil auf, daß diese kostengünstig herstellbar ist und eine vereinfachte Erfassung der Informationen ermöglicht. Eine in der Vorrichtung vorgesehene Meßeinheit weist zumindest zwei Kontaktelemente auf, welche entfernt von der Strahlachse eines elektromagnetischen Strahles an dem optischen Element anordenbar sind. Dadurch kann durch eine einfache Anordnung eine elektrische Widerstandsmessung erfolgen, ohne daß der Strahlweg beeinträchtigt wird. Die bisherige Lagerung und Positionierung der optischen Elemente können im Wesentlichen beibehalten werden. Des Weiteren kann die Vorrichtung an bestehenden Laseranordnungen nachgerüstet werden.

In der nachfolgenden Beschreibung, den Patentansprüchen und den Zeichnungen sind bevorzugte Ausführungsformen der Erfindung näher beschrieben. Es zeigen:
- Figur 1: einen schematischen Aufbau einer Laserbearbeitungsmaschine,
- Figur 2: eine schematische Darstellung einer Anordnung von Kontaktelementen am Trägermaterial eines optischen Elementes zur Erfassung von Informationen,
- Figur 3: eine schematische Seitenansicht der Figur 2,
- Figur 4: eine schematische Darstellung einer nicht erfindungsgemäßen Anordnung von Kontaktelementen an einer Beschichtung des optischen Elementes zur Erfassung von Informationen,
- Figur 5: eine schematische Seitenansicht der Figur 4,
- Figur 6: eine schematische Darstellung einer weiteren alternativen Anordnung und
- Figur 7: ein Diagramm einer Messung eines elektrischen Widerstands von einem optischen Element bei Beaufschlagung mit unterschiedlicher Laserleistung.

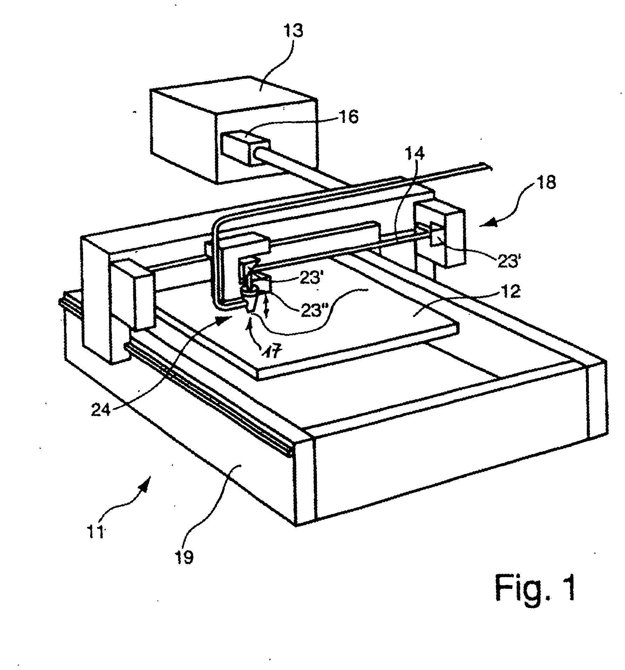

In Figur 1 ist eine Laseranlage 11 dargestellt, welche für die Bearbeitung von Materialien und Werkstücken 12 eingesetzt wird. Die Laseranlage 11 umfaßt eine Laseranordnung mit einem Lasergerät 13, insbesondere einen CO₂-Laser, welches eine elektromagnetische Strahlung insbesondere einen Laserstrahl 14 erzeugt. Die Wellenlänge des Laserstrahls liegt vorzugsweise im fernen Infrarotbereich. An dem Lasergerät 13 ist ein Strahlteleskop 16 vorgesehen, über welches der in dem Lasergerät 13 erzeugte Laserstrahl 14 ausgekoppelt wird. Vom Strahlteleskop 16 bis zur Bearbeitungsstelle 17 wird der Laserstrahl 14 durch eine externe Optik 18 geführt. Die externe Optik 18 ist an einem Maschinengrundgestell 19 vorgesehen, welches in Abhängigkeit der Einsatzfälle ein- oder mehrachsig ausgebildet ist. Im vorliegenden Ausführungsbeispiel wird die externe Optik 18 in einer X-, Y- und Z-Richtung bewegt. Eine ein- oder mehrachsige Optik wird auch als fliegende Optik bezeichnet. Alternativ kann auch das Werkstück und/oder die Optik bewegt sein.

Diese Laseranlage 11 weist eine Vielzahl von optischen Elementen 23 auf. Die in dem Lasergerät 13 erforderlichen optischen Elemente 23 werden auch als interne optische Elemente bezeichnet und umfassen beispielsweise Rückspiegel, Auskoppelspiegel, Umlenkspiegel und teiltransmittierende Spiegel als auch transmittierende Optiken wie Linsen, die nicht näher dargestellt sind. Die externe Optik 18 weist zur Strahlführung und Strahlformung zumindest einen ersten Umlenkspiegel 23' und im Bearbeitungskopf 24 zumindest einen weiteren Umlenkspiegel 23' und eine Fokussieroptik 23" auf, die beispielsweise als Linse ausgebildet ist. Anstelle des weiteren Umlenkspiegels 23' und der Fokussieroptik 23" kann auch ein Hohlspiegel vorgesehen sein. Der Strahlweg des Laserstrahles 14 vom Strahlteleskop 16 bis zur Fokussieroptik 23" ist durch einen Faltenbalg geschlossen gehalten.

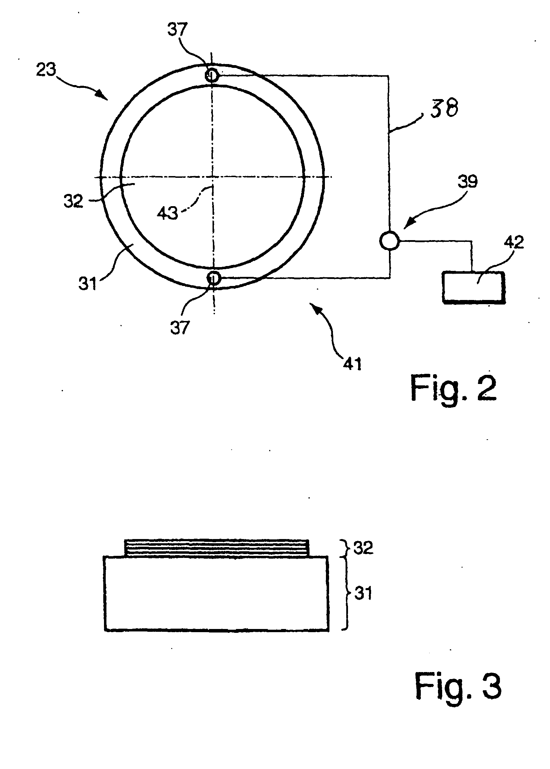

Diese optischen Elemente 23 weisen, wie in den Figuren 2 bis 6 dargestellt ist, ein Trägermaterial 31 aus metallischem Material, einer Legierung oder aus Halbleitermaterial auf. Zumeist bestehen diese optischen Elemente 23 aus Kupfer oder Silicium, wobei das Trägermaterial 31 hierauf nicht beschränkt ist. Auf dem Trägermaterial 31 ist eine Beschichtung 32 vorgesehen. Diese Beschichtung 32 kann unterschiedliche Metalle oder Metallegierungen als auch Halbleitermaterialien umfassen. Ebenso kann eine Multilayerbeschichtung vielfältigster Art vorgesehen sein. In dem Ausführungsbeispiel gemäß den Figuren 2 bis 6 ist beispielsweise ein Trägermaterial 31 aus Silicium vorgesehen und eine Multilayerbeschichtung aus einem Schichtenaufbau, abwechselnd bestehend aus einer Zinkselenid-Schicht und einer ThF4-Schicht. Andere Aufbau- und Materialzusammenstellungen für die optischen Elemente 23 sind in vielfältigen Variationen möglich.

In Figur 2 ist schematisch eine erste Anordnung zur Erfassung eines elektrischen Widerstandes für ein optisches Element 23 dargestellt. An dem Trägermaterial 31 sind Kontaktelemente 37 vorgesehen, welche über eine Leitung 38 Informationen zu einer Meßeinrichtung 39 führen. Die Kontaktelemente 37 sind auf dem Trägermaterial 31 aufgebondet. Alternativ können die Kontaktelemente 37 aufgeklebt, aufgelötet oder mechanisch geklemmt sein. Alternativ kann auch vorgesehen sein, daß gefederte Kontaktstifte mit einer Mindestanpreßkraft an dem Trägermaterial 31 anliegen. Die Kontaktelemente 37, die Meßeinrichtung 39 und die dazwischen liegende Leitung 38 bilden die erfindungsgemäße Vorrichtung 41. Diese Vorrichtung 41 kann zusätzlich eine Auswerteeinheit 42 aufweisen. Alternativ kann diese Auswerteeinheit 42 auch in einer Steuerung der Laseranlage 11 vorgesehen sein.

Die Meßeinrichtung 39 erfaßt einen elektrischen Widerstand, der sich in Abhängigkeit der Temperatur aufgrund der durch den Laserstrahl in dem optischen Element 23 absorbierten Wärme ändert. Die Kontaktelemente 37 sind derart angeordnet, daß deren verbindungslinie 43 die Strahlachse des Laserstrahles schneidet. Die Kontaktelemente 37 können im Randbereich wie dargestellt auf dem Trägermaterial 31 angeordnet sein oder auf der radialen Mantelfläche. Es kann auch vorgesehen sein, daß die Beschichtung 32 Aussparungen zur Aufnahme und Anordnung der Kontaktelemente 37 aufweist.

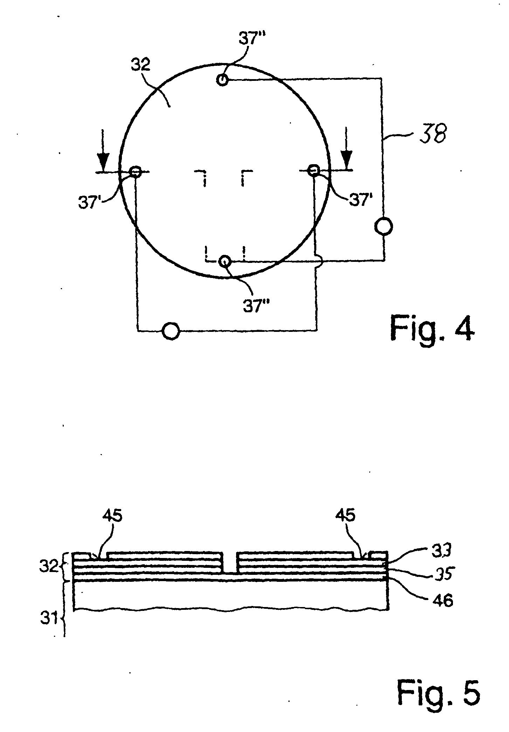

In den Figuren 4 und 5 ist eine nicht erfindungsgemäße Anordnung der Kontaktelemente 37 auf einer Beschichtung 32 dargestellt. Die Beschichtung 32 ist stark vergrößert dargestellt. Bei dieser Anordnung werden von unterschiedlichen Ebenen der leitenden Schichten Ist-Werte abgefragt. Das Paar Kontaktelemente 37' ist beispielsweise mit der oberen leitenden Schicht 33 an den Kontaktflächen 45 verbunden. Das zweite Paar Kontaktelemente 37" ist auf einer darunter liegenden elektrisch leitfähigen Schicht 46 angeordnet. Alternativ kann das zweite Paar Kontaktelemente 37" auch auf dem Trägermaterial 31 angeordnet sein. Die Multilayerbeschichtung ist derart ausgestaltet, daß ein Paar von Kontaktelementen 37' getrennt von einem zweiten Paar Kontaktelementen 37" auf jeweils einer elektrisch leitfähigen Schicht 33, 46 vorgesehen ist, welche durch eine nicht leitfähige Schicht 25 getrennt sind. Bei mehreren leitfähigen Schichten können auf einer oder mehreren Ebenen zumindest ein oder mehrere Kontaktelemente 37 vorgesehen sein.

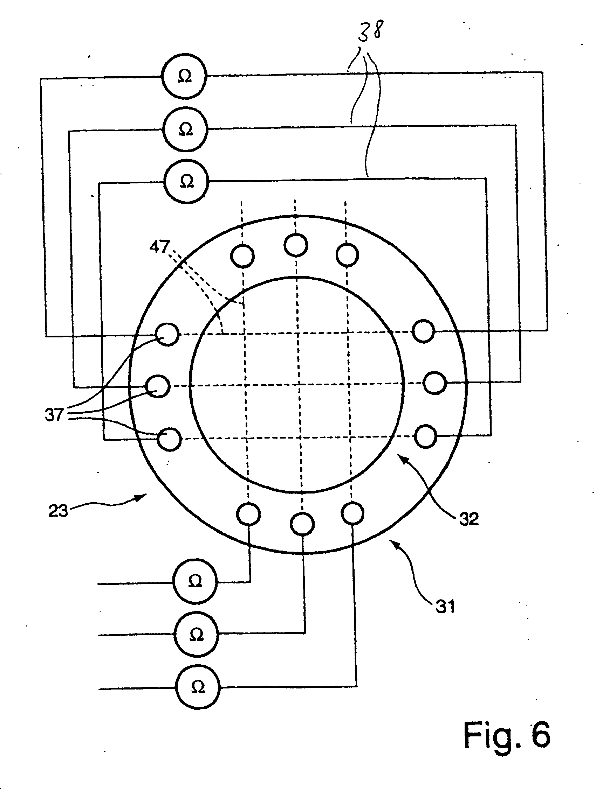

In Figur 6 ist eine alternative Anordnung der Kontaktelemente 37 dargestellt. Die zwischen den paarweise einander gegenüberliegenden Kontaktelementen 37 angeordneten Linien 47 stellen eine schematisch rasterförmige Aufteilung des Meßfeldes dar. Dadurch kann aufgrund der Elnzelerfassung ein annähernder Temperaturverlauf der Oberfläche oder Meßebene des optischen Elements 23 erfaßt werden und beispielsweise die Auftreffläche des Laserstrahls hinreichend bestimmt werden.

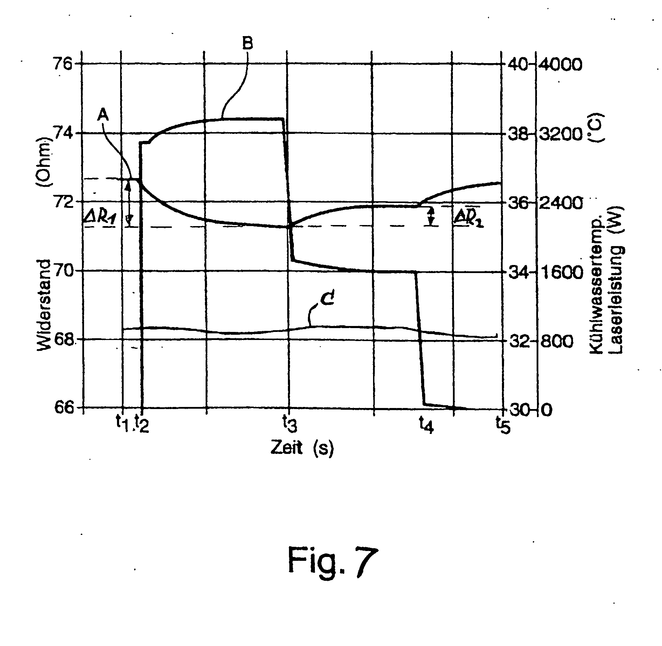

Das in Figur 2 dargestellte optische Element 23 und die daran angebrachte erfindungsgemäße Vorrichtung 41 wurde zur Erstellung des in Figur 7 dargestellten Diagrammes gewählt, um die Verhältnismäßigkeit der Laserleistung zur betragsmäßigen Änderung des elektrischen Widerstandes darzulegen. Von einem optischen Element 23, welches vom Kühlwasser mit einer Temperatur von beispielsweise 32° gemäß Kennlinie C umgeben ist, wurde der elektrische Widerstand zum Zeitpunkt t₁ ermittelt. Dieser Wert und die weiteren erfaßten Werte des elektrischen Widerstandes sind durch die Kennlinie A dargestellt. Zum Zeitpunkt t₂ wird das optische Element 23 mit einer Laserleistung gemäß Kennlinie B von beispielsweise 3.400 W beaufschlagt. Nach einer bestimmten Zeitdauer beispielsweise zwischen 20 und 100 s ist der erfaßbare elektrische Widerstand nahezu konstant. Im Zeitpunkt t₃ ist der elektrische Widerstand um einen Betrag ΔR₁ gegenüber dem Ausgangswert bzw. dem Referenzwert vermindert. Nachfolgend wurde die Laserleistung halbiert, wobei der daraufhin erfaßbare elektrische Widerstand betragsmäßig der Änderung der Laserleistung entspricht. Die betragsmäßige Änderung ΔR₁ wurde halbiert auf ΔR₂, wie die Kennlinie A im Zeitpunkt t₄ zeigt. Die Änderung des elektrischen Widerstandes ist ein Ausführungsbeispiel beispielsweise proportional zur Änderung der Leistung. Die Verhältnisse bestimmen sich im allgemeinen in Abhängigkeit des verwendeten Trägermaterials 31 und der Beschichtung 32 sowie des Einsatzortes der optischen Elemente 23.

Nachdem das optische Element 23 nicht mehr mit einer Laserleistung beaufschlagt ist, kehrt der ermittelte elektrische Widerstand zum Zeitpunkt t₅ auf seinen Ausgangswert zum Zeitpunkt t₁ zurück,

Somit ist die durch die absorbierte Strahlung erzeugte Wärme in dem optischen Element 23 im Ausführungsbeispiel proportional zur Laserleistung und die betragsmäßige Änderung des erfaßten elektrischen Widerstandes eine Größe, welche bezüglich einer beginnenden Verschmutzung, Alterung oder Zerstörung eine Klassifizierung ermöglicht.

Durch die Auswertung der betragsmäßigen Änderung des elektrischen Widerstandes an dem jeweiligen optischen Element 23 ist auch eine Online-Überwachung zur Qualitätssicherung der Laseranlage ermöglicht. Gleichzeitig kann durch Ausnutzung dieses Effektes auch ein frühzeitiger Austausch optischer Elemente bei Vorliegen eines bestimmten Verschmutzungsgrades oder bei einer sich einstellenden oder beginnenden Zerstörung ermöglicht werden. Des weiteren kann eine automatische Abschaltung des Lasergerätes erfolgen, sobald die Laserleistung außerhalb eines oberen oder unteren Grenzwertes eines Referenzwertes erfaßt wird oder sobald die betragsmäßige Änderung des Widerstandes in einem optischen Element einen vorbestimmten Grenzwert überschreitet.

## Patentansprüche

1. Verfahren zur Erfassung von Informationen an zumindest einem optischen Element (23) für die Überwachung einer Anlage, insbesondere zur Überwachung einer Laseranordnung (11), mit den folgenden Merkmalen:
- eine elektromagnetische Strahlung wird von dem zumindest einen optischen Element (23) geformt oder geführt, wobei das optische Element (23) ein Trägermaterial (31) aufweist, auf dem eine Beschichtung (32) vorgesehen ist,
- eine Änderung zumindest einer physikalischen Größe in dem zumindest einen optischen Element (23) wird mit einer Messeinrichtung (39) erfasst, wobei die Änderung der zumindest einen physikalischen Größe durch eine in dem zumindest einen optischen Element (23) absorbierte elektromagnetische Strahlungentsteht und die Messeinrichtung (39) zumindest zwei Kontaktelemente (37) umfasst,
- zumindest ein durch die Messeinrichtung (39) erfasster Ist-Wert wird an eine Auswerteeinheit (42) weitergleitet und der zumindest eine Ist-Wert wird mit einem in der Auswerteeinheit (42) hinterlegten Referenzwert des zumindest einen optischen Elementes (23) verglichen,
**dadurch gekennzeichnet, dass** mit zwei in einer Verbindungslinie einander zugeordneten Kontaktelementen (37), die außerhalb des elektromagnetischen Strahles an dem Trägermaterial (31) des optischen Elements (23) an getracht sind, eine Änderung des elektrischen Widerstandes in dem zumindest einen optischen Element (23) erfasst und an die Auswerteeinheit (42) weitergeleitet wird.

2. Verfahren nach Anspruch 1, **dadurch gekennzeichnet, dass** für jedes optische Element (23) in der Laseranordnung (11) ein Referenzwert von einem Trägermaterial (31) des optischen Elements (23) vor dem Einbau oder vor der Inbetriebnahme in der Laseranordnung (11) erfasst wird.

3. Verfahren nach Anspruch 2, **dadurch gekennzeichnet, dass** der Referenzwert und der beziehungsweise die Ist-Werte an dem Trägermaterial (31) des optischen Elementes (23) erfasst werden.

4. Verfahren nach einem der vorhergehenden Ansprüche, **dadurch gekennzeichnet, dass** der Ist-Wert zeitverzögert nach einem erstmaligen Auftreffen von elektromagnetischer Strahlung auf das optische Element (23) erfasst wird.

5. Verfahren nach einem der vorhergehenden Ansprüche, **dadurch gekennzeichnet, dass** eine Änderung einer Leistung des elektromagnetischen Stahls als Änderung des elektrischen Widerstands erfasst wird und beim Überschreiten oder Unterschreiten eines zu dem Referenzwert des optischen Elementes (23) wählbaren oberen oder unteren Grenzwertes der Leistung ein Signal zur Warnung, Nachregelung oder Abschaltung der Laseranordnung von der Auswerteeinheit (42) ausgegeben wird.

6. Verfahren nach einem der Ansprüche 1 bis 4, **dadurch gekennzeichnet, dass** zur Überwachung der Leistung des elektromagnetischen Strahles von zumindest zwei, vorzugsweise jedem optischen Element (23), Ist-Werte der Messeinrichtung (39) während des Betriebes der Laseranordnung (11) erfasst werden, diese Ist-Werte mit einem gemeinsamen Referenzwert für alle optischen Elemente (23) oder dem jeweiligen optischen Element (23) zugeordneten Referenzwert in der Auswerteeinheit (42) verglichen werden, eine betragsmäßige Abweichung ermittelt und einer entsprechenden Leistung des elektromagnetischen Strahls gleichgesetzt wird und vorzugsweise im Laserresonator der Laseranordnung die erzeugte Laserleistung durch einen thermischen Absorber erfasst wird, welche mit der oder den an den optischen Elementen (23) erfassten Laserleistungen verglichen wird.

7. Verfahren nach einem der vorhergehenden Ansprüche, **dadurch gekennzeichnet, dass** die Ermittlung der Ist-Werte in einen Online-Prozess integriert wird und die Ist-Werte dauerhaft in frei wählbaren Zeitintervallen erfasst werden.

8. Verfahren nach einem der vorhergehenden Ansprüche, **dadurch gekennzeichnet, dass** eine Schar von Kennlinien über unterschiedliche Zustände der optischen Elemente (23) ermittelt wird, dass diese Schar von Kennlinien in der Auswerteeinheit (42) gespeichert wird und zur Auswertung der tatsächlichen Zustände der optischen Elemente (23) mit dem beziehungsweise den Ist-Werten verglichen werden.

9. Vorrichtung zur Erfassung von Informationen an zumindest einem optischen Element (23) für die Überwachung einer Laseranordnung (11) zur Durchführung des Verfahrens nach einem der Ansprüche 1 bis 8, mit einem optischen Element (23), wobei das optische Element (23) ein Trägermaterial (31) aufweist, auf dem eine Beschichtung (32) vorgesehen ist, **dadurch gekennzeichnet, dass** eine Messeinrichtung (39) mit zwei Kontaktelementen (37) zur Erfassung einer Änderung des elektrischen Widerstandes in dem optischen Element (23) vorgesehen ist, die in einer Verbindungslinie und entfernt von einer durch das zumindest eine optische Element (23) geformten oder geführten Strahlachse eines elektromagnetischen Strahles an dem Trägermaterial (31) des optischen Elementes (23) angebracht sind.

## Claims

1. A method for detecting information on at least one optical element (23) for monitoring an arrangement, particularly for monitoring a laser arrangement (11), comprising the following features:
- shaping or guiding an electromagnetic radiation from the at least one optical element (23), comprising a support material (31), on which coating (32) is provided,
- detecting with a measuring device (39) a change in the at least one optical element (23) of at least one physical quantity, where as the change of the at least one physical quantity results from an absorbed electromagnetic radiation in the at least one optical element (23) and the measuring device (39) comprises at least two contact elements (37),
- forwarding at least one actual value detected by the measuring device (39) to an evaluations unit (42) and comparing the at least one actual value with a reference value of the at least one optical element (23) deposited in the evaluation unit (42),
**characterized in that** a change for the electrical resistance in the at least one optical element (23) is detected with two contact elements (37) fixed to each other in one connection line outside of the electromagnetic beam on the support material (31) of the optical element (23) and is forwarded to the evaluation unit (42).

2. Method according to claim 1, **characterized in that** for each optical element (23) of the laser arrangement (11) a reference value of a support material (31) of the optical element (23) is detected before mounting of before initial operation in the laser arrangement (11).

3. Method according to claim 2, **characterized in that** the reference value and respectively the actual value is detected on the support material (31) of the optical element (23).

4. Method according to one of the preceding claims, **characterized in that** the actual value is detected with a time delay after the electromagnetic radiation first strikes the optical element (23).

5. Method according to one of the preceding claims, **characterized in that** a change of a power of the electromagnetic beam is detected as a change of the electrical resistance and on exceeding or falling below an upper or lower limiting value of the power which is selected for the reference value of the optical element (23), a signal is emitted by the evaluation unit (42) for warning, readjustment or switching off the laser arrangement.

6. Method according one of the claims 1 to 4, **characterized in that** for monitoring the power of the electromagnetic beam actual values of the measuring device (39) are detected of at least two optical elements (23), preferably of each optical element (23), during the operation of the laser arrangement (11), these actual values are compared in the evaluation unit (42) with a common reference value for all the optical elements (23) or with a reference value allocated to the respective optical element (23), a quantitative deviation is determined and equated to a corresponding power of the electromagnetic beam and preferably a laser power produced in the laser resonator of a laser arrangement is detected by a thermal absorber, which is compared with the laser power detected on the optical element (23) or the laser powers on the optical elements (23).

7. Method according to one of the preceding claims, **characterized in that** the determination of the actual values is integrated into an online-process and the actual values are permanently detected at freely selectable and established time intervals.

8. Method according to one of the preceding claims, **characterized in that** a set of characteristic curves for different states of the optical elements (23) is detected, that this set of characteristic curves is stored in the evaluation unit (42) and is compared with the actual value or values for the evaluation of the actual states of the optical elements (23).

9. A device for detecting information on at least one optical element (23) for monitoring a laser arrangement (11) for performing the method according to one of the claims 1 to 8, with an optical element (23) having a support material (31), on which a coating (32) is provided, **characterized in that** a measuring device (39) is provided with two contact elements (37) for detecting a change of the electrical resistance in the optical element (23), which contact elements (37) are fixed on the support material (31) of the optical element (23) in one connection line outside from a beam axis of the electromagnetic beam which is shaped and guided by at least one optical element (23).

## Revendications

1. Procédé de saisie d'informations sur au moins un élément optique (23) pour le contrôle d'une installation, notamment pour le contrôle d'un dispositif laser (11), avec les caractéristiques suivantes :
- un rayonnement électromagnétique est formé ou guidé par cet élément optique (23) au moins, l'élément optique (23) comportant un matériau de support (31) sur lequel un revêtement (32) est prévu,
- une modification d'au moins une grandeur physique dans cet élément optique (23) au moins est enregistrée par un équipement de mesure (39), la modification de cette grandeur physique au moins par un rayonnement électromagnétique absorbé se produisant dans cet élément optique (23) au moins et l'équipement de mesure (39) comportant au moins deux éléments de contact (37)
- au moins une valeur réelle enregistrée par l'équipement de mesure (39) est acheminée vers une unité d'exploitation (42) et cette une valeur réelle au moins est comparée à une valeur de référence déposée dans l'unité d'exploitation (42) de cet élément optique (23) au moins,
**caractérisé en ce qu'**avec deux éléments de contact (37) mutuellement alignés, qui sont fixés sur le matériau de support (31) de l'élément optique (23) à l'extérieur du rayon électromagnétique, on mesure une modification de la résistance électrique dans cet élément optique (23) au moins et on l'achemine vers l'unité d'exploitation (42).

2. Procédé selon la revendication 1, **caractérisé en ce que** pour chaque élément optique (23) dans le dispositif laser (11), on enregistre une valeur de référence d'un matériau de support (31) de l'élément optique (23) avant le montage ou avant la mise en service dans le dispositif laser (11).

3. Procédé selon la revendication 2, **caractérisé en ce qu'**on enregistre la valeur de référence et la respectivement les valeurs réelles sur le matériau de support (31) de l'élément optique (23).

4. Procédé selon une des revendications précédentes, **caractérisé en ce qu'**on enregistre la valeur réelle un certain temps après un premier impact du rayonnement électromagnétique sur l'élément optique (23).

5. Procédé selon une des revendications précédentes, **caractérisé en ce qu'**une modification de la puissance du rayonnement électromagnétique est enregistrée sous la forme d'une modification de la résistance électrique et que le fait de passer au-dessus ou au-dessous d'une valeur limite de référence de la puissance haute ou basse choisie de l'élément optique (23) génère à partir de l'unité d'exploitation (42) un signal d'avertissement, de réglage ou d'arrêt du dispositif laser.

6. Procédé selon une des revendications 1 à 4, **caractérisé en ce que** pour le contrôle de la puissance du rayon électromagnétique, on enregistre des valeurs réelles d'au moins deux éléments optiques, de préférence celles de chaque élément optique (23), de l'équipement de mesure (39) pendant le fonctionnement du dispositif laser (11), on compare dans l'unité d'exploitation (42) ces valeurs réelles à une valeur de référence commune à tous les éléments optiques (23) ou à la valeur de référence attribuée à l'élément optique (23) correspondant, on détermine une déviation de sa valeur et on identifie une puissance correspondante du rayon électromagnétique et de préférence la puissance laser générée dans le résonateur laser du dispositif laser au moyen d'un absorbeur thermique, qui est comparée à la ou les puissances laser enregistrées sur les éléments optiques (23).

7. Procédé selon une des revendications précédentes, **caractérisé en ce que** l'enregistrement des valeurs réelles est intégré dans un processus en temps réel et. que les valeurs réelles sont enregistrées en permanence à des intervalles de temps pouvant être choisis librement.

8. Procédé selon une des revendications précédentes, **caractérisé en ce qu'**on enregistre une série de caractéristiques concernant différents états des éléments optiques (23), **en ce qu'**on mémorise cette série de caractéristiques dans l'unité d'exploitation (42) et que pour exploiter les états réels des éléments optiques (23), on la compare avec la ou les valeurs réelles respectives.

9. Dispositif de saisie d'informations sur au moins un élément optique (23) pour le contrôle d'un dispositif laser (11), pour exécuter le procédé selon une des revendications 1 à 8 avec un élément optique (23), l'élément optique (23) comportant un matériau de support (31) sur lequel un revêtement (32) est prévu, **caractérisé en ce qu'**un équipement de mesure (39) avec deux éléments de contact (37) est prévu pour enregistrer une modification de la résistance électrique dans l'élément optique (23), qui sont fixés sur le matériau de support (31) de l'élément optique (23), alignés et distants de l'axe du rayon d'un rayon électromagnétique formé ou guidé par cet élément optique (23) au moins.
